# EUROPÄISCHE PATENTSCHRIFT

(11) **EP 1 761 964 B1**
(45) Veröffentlichungstag und Bekanntmachung des Hinweises auf die Patenterteilung: **26.05.2010**
(21) Anmeldenummer: 05707147.4
(22) Anmeldetag: 02.02.2005
(51) Int. Cl.: H01M 8/00, H01M 8/10, H01M 8/24

(54) **CHIP MIT VERSORGUNGSEINRICHTUNG**
CHIP WITH A POWER SUPPLY DEVICE
PUCE POURVUE D'UN DISPOSITIF D'ALIMENTATION

(30) Priorität: 30.04.2004 DE 102004021346
(43) Veröffentlichungstag der Anmeldung: 14.03.2007
(73) Patentinhaber: Micronas GmbH, 79108 Freiburg (DE)
(72) Erfinder: LEHMANN, Mirko, 79117 Freiburg (DE); SIEBEN, Ulrich, 79279 Vörstetten (DE)
(74) Vertreter: Westphal, Klaus
(86) Internationale Anmeldenummer: PCT/EP2005/001033
(87) Internationale Veröffentlichungsnummer: WO 2005/109552

(56) Entgegenhaltungen:
- EP-A- 0 971 410
- EP-A- 1 089 219
- EP-A2- 0 337 684
- FR-A- 2 822 572
- FR-A1- 2 828 298
- JP-A- 2003 296 196
- US-A1- 2002 047 049
- US-A1- 2003 019 942
- US-A1- 2003 024 994

## Beschreibung

Die Erfindung bezieht sich auf einen Chip mit einer Versorgungseinrichtung gemäß den oberbegrifflichen Merkmale des Anspruchs 1.

Ein solcher Chip ist z.B. aus US-A-2003/0024994 bekannt.

Die elektrische Spannungs- bzw. Stromversorgung für Chips, d. h. verschiedenartigste Arten von integrierten Sohaltungsanordnungen und dergleichen erfolgt üblicherweise über eine Betriebsspannung, welche von einer externen Energiequelle aus angelegt wird. Externe Energiequellen sind typischerweise Verbindungen zu einem Stromnetz oder in elektrischen Vorrichtungen eingesetzte Batterien oder Akkumulatoren.

Anstelle von Batterien oder Akkumulatoren können auch Brennstoffzellenanordnungen eingesetzt werden. Brennstoffzellen bestehen üblicherweise aus einer ersten und einer zweiten Elektrodenanordnung, von denen eine als Anode und die andere als Kathode dient. Zwischen den beiden Elektrodenanordnungen befindet sich eine Membran-Elektroden-Einheit (MEA) mit katalytischer Eigenschaft, welche als protonendurchlassende Membran mit katalytischer Beschichtung dient. Weiterhin weist eine derartige Brennstoffzelle eine Brennstoff-BereitstellungsEinrichtung zum Zuführen eines Brennstoffs, typischerweise Wasserstoff, und eine Reaktant-Bereitstellungseinrichtung zum Zuführen eines Reaktants, typischerweise Sauerstoff, auf. Das Reaktant reagiert zur Stromerzeugung mit Protonen, die aus dem Brennstoff stammen und durch die Membran hindurchgetreten sind. Das Verbrannungsandgrodukt, typischerweise Wasser, wird von der Brennstoffzellenanordnung ausgeschieden.

Chips weisen oftmals einen integrierten Speicher zum Speichern von vertraulichen Daten auf. Derartige vertrauliche Daten können z. B. Kontozugangsinformationen eines Kontos und Identifikationsinformationen einer Person sein. Gelangt der Chip in unberechtigte Hände, so besteht prinzipiell die Gefahr, dass die im Chip enthaltenen Daten durch eine unberechtigte Person ausgelesen und missbraucht werden können.

Um einen Chip gegen Manipulationen zu sichern, gibt es nur allenfalls bedingt brauchbare Lösungen, z. B. Bohrschutzfolien, welche in ein Package bzw. Gehäuse des Chips integriert werden.

Allgemein bekannt ist aus WO 02/058219 A2 eine Energie-Speichereinrichtung, deren Oberfläche ausgebildet ist, Energie eines zugeführten Mediums aufzunehmen, wobei die Energie in einer benachbarten Halbleiteranordnung gespeichert wird. Die Energie wird zum Erzeugen von Licht oder einer elektromagnetischen Strahlung mittels der Anordnung verwendet. Ausgenutzt werden bei dieser Anordnung somit Oberflächenenergien.

Die Aufgabe der Erfindung besteht darin, einen Chip mit einer Versorgungseinrichtung bereitzustellen, wobei im Chip gespeicherte Daten besser gesichert werden sollen, insbesondere gegen einen unberechtigten Zugriff besser gesichert werden sollen.

Diese Aufgabe wird durch den Chip mit einer Versorgungseinrichtung und mit einem Speicher zum Speichern von vertraulichen Daten mit den Merkmalen des Patentanspruchs 1 gelöst.

Vorteilhafte Ausgestaltungen sind Gegenstand abhängiger Ansprüche.

Erfindungsgemäß weist der Chip eine Sicherungsschaltung zum Zerstören von betriebswesentlichen Bestandteilen des Chips im Fall eines unberechtigten Eingriffs auf. Dabei stellt die integrierte Versorgungseinrichtung eine Betriebsspannung für die Sicherungschaltung bereit. Vorteilhafterweise ist eine Umsetzung auch auf Anordnungen mit einer externen, d.h; nicht integrierten Versorgungseinrichtung möglich. Kombiniert damit oder alternativ dazu kann der Chip mit einer Sicherungsschaltung zum Löschen der Daten in dem Speicher, insbesondere einem ROM (Read Only Memory) im Fall eines unberechtigten Eingriffs ausgebildet sein, wobei die Versorgungseinrichtung eine Betriebsspannung für die Sicherungsschaltung bereitstellt. Gemäß einer solchen Ausführungsform weist der Chip somit eine Sicherungsschaltung auf, welche auf eine eigenständige Versorgungseinrichtung zugreift. Das Herauslösen des Chips aus einer Schaltungsanordnung mit einer externen Versorgung verhindert somit nicht die Funktionstüchtigkeit der Sicherungsschaltung.

Erfindungsgemäß ist des weiteren, was auch mit der vorstehenden Variante kombinierbar ist, die Sicherungsschaltung aus einer Barriere für ein Reaktant zum Betreiben einer Brennstoffzelle mit einem Brennstoff als der Versorgungseinrichtung auszubilden, wobei eine Beschädigung der Barriere zum Zutritt des Reaktants zu der Brennstoffzelle führt. Mit anderen Worten ist die Versorgungseinrichtung aus einer Brennstoffzelle ausgebildet, in welcher ein Brennstoff, insbesondere Wasserstoff, integriert ist. Zum Bereitstellen einer Spannung für die Sicherungsschaltung fehlt der Brennstoffzelle jedoch das Reaktant, beispielsweise Sauerstoff. Die Barriere kann durch eine eigenständige Schutzhülle um die zu sichernden Baukomponenten des Chips ausgebildet sein, im einfachsten Fall durch das Gehäuse des Chips. Eine Beschädigung der Barriere bzw. des Gehäuses führt zum Zutritt von Luft und somit Sauerstoff, so dass die Brennstoffzelle aktiviert wird und eine Spannung als Löschspannung an die Sicherungsschaltung anlegt.

Besonders vorteilhaft ist demgemäss ein Chip mit einem Speicher zum Speichern von insbesondere vertraulichen Daten mit einer Versorgungseinrichtung zum Anlegen einer Spannung und/oder eines Stroms und mit einer Schnittstelle zum Übertragen von Daten von und/oder zu einer anderen Einrichtung dann, wenn die Versorgungseinrichtung Bestandteil, insbesondere integraler Bestandteil des Chips ist. Betriebsrelevante Komponenten des Chips, wie z. B. der Speicher mit den Daten, können somit auf eine eigenständige Versorgungseinrichtung zugreifen, welche zur Sicherung der vertraulichen Daten in dem Speicher einsetzbar ist.

Gemäß einer ersten besonders bevorzugten Ausführungsform eines solchen Chips liegt an dem Speicher eine Aufrechterhaltungsspannung zum Aufrechterhalten der Daten an, wobei die Daten bei Ausfallen der Aufrechterhaltungsspannung gelöscht werden und wobei die Aufrechterhaltungespanrsung insbesondere ausschließlich von der Versorgungseinrichtung bereitgestellt wird. Vorteilhafterweise ist eine Umsetzung auch auf Anordnungen mit einer externen, d.h. nicht integrierten Versorgungseinrichtung möglich. Diese Ausführungsform bewirkt, dass die Daten in z. B. einem RAM (Random Access Memory) nur so lange gespeichert werden, wie die Spannungsversorgungseinrichtung in der Lage ist, eine ausreichende Aufrechterhaltungsspannung bereitzustellen. Letztendlich ist dadurch die Lebensdauer der vertraulichen Daten bzw. die Lebensdauer des gesamten Chips begrenzt, wobei die Zeitdauer durch eine entsprechende Dimensionierung der Versorgungseinrichtung vorbestimmbar ist. Eine Smart Card, welche beispielsweise im Bankverkehr von Bankkunden eingesetzt wird, kann somit auf eine maximale Funktionsdauer beschränkt werden. Eine Begrenzung der Einsetzbarkeit ist somit nicht nur durch einen auf der Karte aufgedruckten Ablaufvermerk und eventuelle Sperrvermerke in zentralen Datenbanken sondern auch durch eine generelle maximale Lebensdauer des Chips bzw. der Karte gesichert.

Gemäß einer zweiten Ausführungsform, die vorteilhafterweise auch mit der ersten Ausführungsform kombinierbar ist, ist der Chip derart aufgebaut, dass zum Anlegen der Aufrechterhaltungsspannung ein Sicherungsleiter den Speicher und die Versorgungseinrichtung miteinander verbindet, wobei der Sicherungsleiter im Chip derart verlaufend angeordnet ist, dass der Sicherungsleiter bei einer Beschädigung des Chips unterbrochen wird. Eine mechanische Beschädigung des Chips bzw. des Gehäuses des Chips führt somit zu einer Unterbrechung des Sicherungsleiters, was eine sofortige Unterbrechung der Aufrechterhaltungsspannung zur Folge hat. Dadurch gehen die vertraulichen Daten im Speicher verloren bzw. werden gelöscht. Ein Öffnen des Chips, um nach Freilegen der eigentlichen integrierten Schaltungsanordnung direkten Zugriff auf Leiterbahnen zu erlangen, wird somit ausgeschlossen.

Die Anordnung, insbesondere die Sicherungsschaltung ermöglicht einen je nach Ausgestaltung anpassbaren Schutz von insbesondere verschlüsselten Daten in dem Chip. Bei einem unberechtigten Versuch, Daten auszulosen wird die Energie auf dem Chip verwendet, um die RAMs und/oder ROMs zu löschen. Bei RAMs gemäß z.B. der ersten Ausführungsform kostet die Aufrechterhaltung der Daten Energie, so dass ein Ausfall oder Abschalten der Energie zum Löschen der Daten führt. Bei ROMs gemäß z. B. der dritten Ausführungsform keine Energie, so dass mit der Energie eine aktive Löschung vorgenommen wird.

Die Sicherungsschaltung kann kombiniert oder alternativ auch mit Sensoren ausgestattet sein, wie z. B. Gassensoren, Ultraschallsensoren, Magnetfeldsensoren, optischen Sensoren, Biosensoren etc., welche einen Alarm auslösen oder eine sonstige Funktion der Sicherungsschaltung aktivierten, wenn der Chip in eine betriebsfeindliche Umgebung kommt und entsprechende Auslösekriterien für die Sensoren erfüllt werden oder alternativ vorausgesetzte Umgebungsbedingungen ausfallen. Daraufhin werden dann auf dem Chip sieherheitsrelevante und vertrauliche Daten oder auch alle Daten gelöscht.

Gemäß einer Variante dieser dritten Ausführungsform ist die Sicherungsschaltung zum Überwachen einer anliegenden Betriebsspannung ausgebildet und löscht die Daten für den Fall einer Unterbrechung der Betriebsspannung. Ein Herauslösen des Chips aus seiner Betriebsumgebung führt somit aufgrund der Unterbrechung der Betriebsspannung zu der Aktivierung der Siaherungsschaltung, welche mit Hilfe der eigenen Versorgungseinrichtung das Löschen der Daten in dem Speicher bewirkt.

Während die beiden ersten Ausführungsformen auf dem Grundprinzip beruhen, eine eigenständige Aufrechterhaltungsspaimung zum Aufrechterhalten der Daten im Speicher des Chips bereitzustellen, sehen die Varianten der dritten Ausführungsform eine Sicherungsschaltung vor, welche mit Hilfe der integriert bereitgestellten Spannung bei einem unberechtigten Eingriff aktiv die Löschung der Daten im Speicher bewirkt. Unter Speicher sind dabei beliebige speichernde Strukturen zu verstehen.

Ein gemäß den verschiedenen Ausführungsformen.betriebener Chip weist vorteilhafterweise einen Betriebsspannungsanechluss zum Anlegen einer Betriebsspannung zum Betreiben von allgemeinen Funktionen des Chips von einer externen Spannungsquelle auf. Diese Ausführungsform ermöglicht die Bereitstellung einer integrierten Versorgungseinrichtung mit einer nur geringen Kapazität, da leistungsintensive Funktionen beim Betrieb des Chips durch eine externe Spannungsquelle versorgt werden können. In üblicher Art und Weise wird die Betriebsspannung beispielsweise über Kontakte oder induktiv bereitgestellt. Insbesondere bei dieser Ausführungsform ist der Einsatz der Versorgungseinrichtung, welche im Chip integriert ist, auch in Verbindung mit einer Notstromschaltung zum Bereitstellen der Betriebsspannung von der Versorgungseinrichtung beim Ausfallen der Betriebsspannung von der externen Spannungsquelle vorteilhaft. Dadurch können insbesondere kurzzeitige Störungen der externen Betriebsspannung gepuffert werden.

Bei allen Ausführungsformen ist die Versorgungseinrichtung gemäß besonders bevorzugter Ausführungsform eine Brennstoffzelle mit einer vorgegebenen Menge an Brennstoff. Der Brennstoff wird z. B. in einem Palladiumspeicrer gespeichert. Der Einsatz einer Brennstoffzelle bietet unter anderem den Vorteil, dass Leistungs- bzw. Kapazitätsverluste aufgrund einer zunehmenden Lagerzeit geringer als bei anderen Spannungsquellen sind. Die vorgegebene Menge an Brennstoff wird vorteilhafterweise begrenzt, um eine nur begrenzte Menge an Brennstoff zum Bereitstellen einer Strommenge für eine begrenzte Lebensdauer des Chips bzw. des Speicherinhalts bereitzustellen. Dies bedeutet, dass die Brennstoffzelle vorzugsweise derart aufgebaut ist, dass eine Auffüllung verbrauchten Brennstoffs nicht möglich ist. Insbesondere bei der Ausführungsform mit einer Brennstoffzelle als Versorgungseinrichtung zum Bereitstellen einer Aufrechterhaltungsspannung für vertrauliche Daten in dem Speicher ist somit die Lebensdauer des gesamten Chips für eine vorgebbare maximale Zeitspanne einstellbar. Mit Zusammenbruch der Aufrechterhaltungsspannung bzw. Unterschreiten eines mindesterforderlichen Schwellenspannungswertes gehen die vertraulichen Daten in dem flüchtigen Speicher verloren.

Bevorzugt wird insbesondere ein Chip, bei dem die Daten vertrauliche Daten sind, insbesondere einen für den Betrieb des Chips erforderlichen Schlüssel oder dergleichen enthalten. Beispielsweise kann ein solcher Chip bei der Herstellung mit einem Schlüssel, beispielsweise einem cryptologischen Schlüssel oder einer Zufallszahl versehen werden, wobei diese vertraulichen Daten für den Betrieb des Chips oder für eine Verwertung der darauf ansonsten gespeicherten Daten erforderlich sind. Bei einer Betriebsstörung oder einem unberechtigten Zugriff werden diese vertraulichen Daten gelöscht oder mit falschen Daten überschrieben, um den Chip oder darauf gespeicherte Daten unbrauchbar zu machen. Bei einer solchen Vorgehensweise kennt nur der Chip seinen Schlüssel bzw. seine entsprechenden vertraulichen Daten.

Möglich ist auch, dass der Chip selber einen Schlüssel generiert, den nur er selber kennt. Diese Generierung eines solchen Schlüssels geschieht vorzugsweise unter Verwendung eines Zufallsgenerators bei der Herstellung des Chips oder auch zu einem späteren Zeitpunkt. Vorzugsweise deckt die Versorgungseinrichtung den Speicherbereich ab, in dem der Schlüssel gespeichert wird, bzw. schützt diesen Speicherbereich. Bevorzugt wird dabei ein Chip mit einem Zufallsgenerator zum Erzeugen des für den Betrieb des Chips erforderlichen und in dem Speicher gespeicherten Schlüssels, insbesondere zum Erzeugen des Schlüssels bei der Herstellung oder bei der erstmaligen Aktivierung des Chips.

Gemäß besonders bevorzugter Ausführungsform wird durch die Versorgungseinrichtung insbesondere der Speicherbereich mit den vertraulichen Daten gesichert bzw. versorgt, so dass dafür auf eine externe Batterie oder dergleichen verzichtet werden kann. Auch bei dieser Ausführungsform wird eine Variante mit einer Brennstoffzelle als der Versorgungseinrichtung besonders bevorzugt.

Anstelle einer Löschung von Daten oder einer Zerstörung von relevanten Betriebskomponenten kann gemäß einer weiteren vorteilhaften Ausführungsform auch das Aufspielen von falschen Daten in einen Speicherbereich im Fall eines unberechtigten Zugriffs auf den Speicher oder auf den Chip oder dergleichen vorgenommen werden. Ein unberechtigtes Auslesen dieser Daten führt dann dazu, dass der Unberechtigte mit diesen Daten nichts anfangen kann, möglicherweise sogar Schaden erleidet oder auch durch eine entsprechende Überwachung ermittelbar ist.

Neben der Möglichkeit, die Versorgungseinrichtung, insbesondere die Brennstoffzelle als Versorgungseinrichtung neben den anderen Komponenten innerhalb des Gehäuses des Chips anzuordnen, wird eine Ausführungsform besonders bevorzugt, bei der die Versorgungseinrichtung integraler Bestandteil des eigentlichen Speichers ist.

Besonders bevorzugte Anwendungsbereiche sind insbesondere Identifizierungskarten und Kreditkarten mit einem solchen Chip, der den Speicher zum Speichern von vertraulichen Daten und die Versorgungseinrichtung mit der begrenzten Strommenge zum Speichern der Daten im Speicher über eine nur begrenzte Dauer aufweist.

Vorteilhafterweise können die einzelnen beispielhaften Ausführungsformen hinsichtlich ihrer technischen Merkmale auch unter Ausbildung weiterer Ausführungsformen untereinander kombiniert werden.

Ausführungsbeispiele der Erfindung werden nachfolgend anhand der Zeichnung näher erläutert. Es zeigen:
- Figur 1: eine erste Ausführungsform eines ersten Ausführungs- beispiels mit einem Chip, welcher eine integrierte Versorgungseinrichtung aufweist;
- Figur 2: eine zweite Ausführungsform des ersten Ausführungs- beispiels mit zusätzlich einem Sicherungsleiter zum Verhindern eines unberechtigten mechanischen Zugriffs auf Komponenten innerhalb des Chips;
- Figur 3: eine weitere Ausführungsform, zugleich erste Ausfüh- rungsform eines zweiten Ausführungsbeispiels, wobei der Chip neben einer integrierten Versorgungseinrich- tung eine von dieser mit Spannung versorgte Siche- rungsschaltung aufweist; und
- Figur 4: eine weitere Ausführungsform mit einer Sicherungs- schaltung.

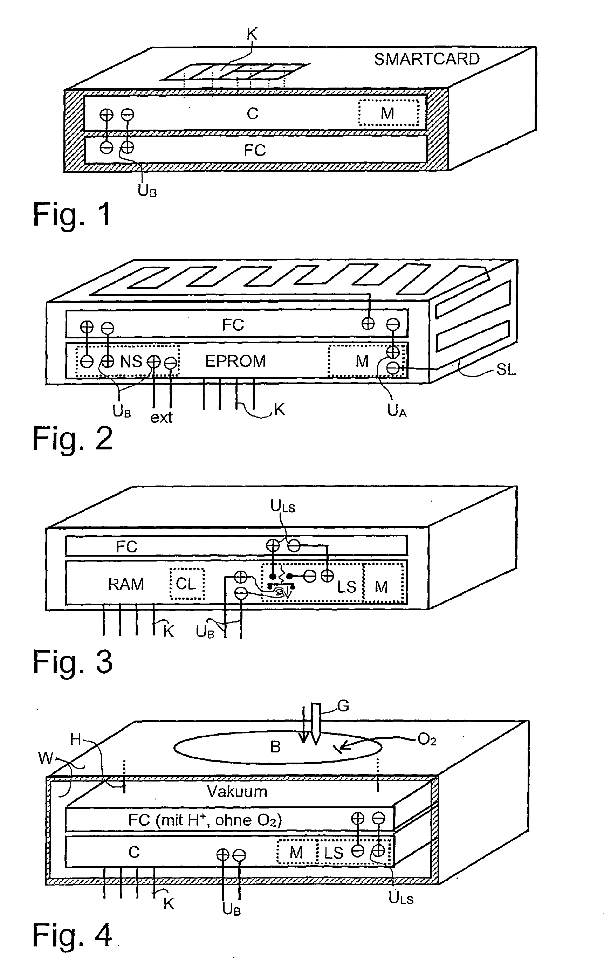

Figur 1 zeigt eine erste einfache Ausführungsform eines Chips schematisch in Teilschnittansicht. Vom Grundprinzip her zeigt das dargestellte Ausführungsbeispiel eine Kreditkarte mit integrierter Smartcard.

Neben einem eigentlichen Prozessor C ist in dem Chip auch eine Versorgungseinrichtung, insbesondere eine Spannungsversorgungseinrichtung FC integriert. Prinzipiell kann eine beliebige Spannungsversorgungseinrichtung in Art üblicher Batterien eingesetzt werden. Besonders bevorzugt wird jedoch eine Brennstoffzelle FC als Spannungsversorgungseinrichtung. Die Spannungsversorgungseinrichtung FC stellt eine Betriebsspannung U_{B} für den Prozessor C bereit. Die Betriebsspannung U_{B} wird über entsprechende Verbindungsleiter zwischen der Spannungsversorgungseinrichtung FC und dem Prozessor C am Prozessor C angelegt.

Der Prozessor C kann eine beliebige integrierte Schaltungsanordnung in für sich bekannter Art und Weise sein, die bei dem dargestellten Ausführungsbeispiel mit einer Schnittstelle K zum Übertragen von Daten zu einer externen Einrichtung verbunden ist. Die dargestellte Schnittstelle K wird durch ein Kontaktfeld an der Oberfläche des Chips bzw. der Smartcard ausgebildet.

In den Chip integriert ist ein Speicher M zum flüchtigen Zwischenspeichern oder dauerhaften Speichern von Daten. Neben der Integration des Speichers M in dem Prozessor C kann der Speicher M auch als eigenständige Baugruppe neben dem Prozessor C und neben der Spannungsversorgungseinrichtung FC bereit gestellt werden. Der Speicher M kann auch direkt mit der Spannungsversorgungseinrichtung FC verbunden oder als Bestandteil von deren Baugruppe ausgebildet werden.

Der dargestellte Chip bietet den Vorteil einer eigenständigen Spannungsversorgung des Prozessors C mit der Betriebsspannung U_{B} von der im Chip integrierten Spannungsversorgungseinrichtung FC. Die Betriebsspannung U_{B} kann dabei insbesondere als Aufrechterhaltungsspannung für im Speicher M gespeicherte Daten verwendet werden.

Beispielsweise kann eine erste Elektrode der Brennstoffzelle FC aus einer Palladium-Schicht mit einer Fläche von 1 mm² und mit einer Mächtigkeit von 1 µm während des Herstellungsprozesses mit insbesondere Wasserstoff als Brennstoff gesättigt werden. Bevorzugtes Ziel bei einer solchen Anordnung ist es, mit diesem Wasserstoff auszukommen, also nicht irgendwelche zusätzliche Zufuhreinrichtungen für Wasserstoff oder entsprechende Energieträger vorzusehen. Die Sauerstoffzufuhr erfolgt vorteilhafterweise über die Umgebungsluft. Durch ein einmaliges Beaufschlagen von Wasserstoff können vorzugsweise getaktete Halbleiterschaltungen auf diese Art und Weise mit dieser chip-integrierten Stromquelle versorgt werden, um beispielsweise ein autarkes Mikrosystem, wie z. B. eine Alarmanlage oder ein intelligentes Pflaster auszubilden.

Durch ein einmaliges Beaufschlagen von Wasserstoff kann bei dem beschriebenen Beispiel gemäß ersten Berechnungen und je nach Diffusionsbedingungen des Wasserstoffs ein zehn Sekunden andauernder Stromfluss mit einer Stromstärke in der Größenordnung von mehreren hundert µA erzeugt werden. Alternativ können auch Ausgestaltungen vorgesehen werden, welche eine Nachfüllung des Wasserstoffs ermöglichen. Einfache Halbleiterschaltungen bzw. Chip können auf diese Art und Weise mit einer integrierten Stromquelle versehen werden, um beispielsweise eine Alarmanlage auszubilden. Damit steht auf dem Chip eine ausreichende Energiemenge zur Verfügung, um eine Schaltungsanordnung, z. B. den Prozessor C zu betreiben oder um den Speicher M über eine lange Zeitdauer mit einer Aufrechterhaltungsspannung zu versorgen.

Mit einer solchen integrierten Brennstoffzelle auf dem Chip kann daher ein Speicher, z. B. ein RAM (Direktzugriffsspeicher/Random Access Memory) und/oder ein FPGA (Field Programmable Gate Array/ Programmierbare Feld-Gatter-Anordnung) auf einem Chip aufrechterhalten werden.

Sofern die Daten vertrauliche Daten sind und der Speicher M ein flüchtiger Speicher ist, dessen Daten bei Unterbrechung der Aufrechterhaltungsspannung verloren gehen bzw. gelöscht werden, bietet sich der weitere Vorteil, dass eine Beschädigung des Chips für den Fall der Unterbrechung der Betriebsspannung U_{B} bzw. der Aufrechterhaltungsspannung zwangsläufig auch zum Verlust der vertraulichen Daten führt. Eine Manipulation direkt an der Brennstoffzelle FC oder im Bereich der Spannungsversorgung des Speichers M hätte somit sofort zur Folge, dass die Daten gelöscht werden, da die Energie für die Aufrechterhaltung fehlt.

Ein beispielhafter Chip zur digitalen Signalverarbeitung (DSP-Chip) hat beispielsweise eine Chip-Größe von 225 mm² für die Komponenten zur digitalen Signalverarbeitung und zusätlich von etwa 1 cm²x100 µm für die Brennstoffzelle FC. Bei einer Betriebsfrequenz von 13,2 MHz, einer Betriebsspannung von 1,0 V und einem Leistungsverbrauch von 29 mW wäre bei einem derzeitigen Chip eine Bereitschaftsleistung (Stand-By-Power) von 350 µW im aktiven Zustand zu veranschlagen. Im nicht aktiven, schlafenden Zustand wäre der Leistungsverbrauch mit 600 nW zu veranschlagen. Mit dieser Annahme könnte die Brennstoffzelle FC über eine Dauer von 700 Tagen eine Leistung von 700 nW liefern. Im Fall des Einsatzes des Chips als Bestandteil einer Kreditkarte oder Bankkarte könnten somit vertrauliche Daten im Speicher M über eine Dauer von 700 Tagen aufrechterhalten werden. Danach würden die Daten mangels Aufrechterhaltungsspannung verloren gehen und die Karte mit dem Chip für einen weiteren Einsatz unbrauchbar werden. Der Verlust einer Karte oder die nicht mit offiziellem Ablaufdatum erfolgte Vernichtung einer Karte würde somit ein nur begrenztes Sicherheitsrisiko darstellen.

Figur 2 zeigt eine zweite Ausführungsform eines Chips mit integrierter Schaltungsanordnung, beispielsweise einem EPROM (Erasable Programmable Read-Only Memory / Änderbarer programmierbarer Festwertspeicher), und einer Brennstoffzelle FC als integrierter Spannungsversorgungseinrichtung FC. Als externe Schnittstelle K zur Datenübertragung dienen beispielsweise für einen Chip übliche Kontaktstifte K. Über zwei weitere Kontaktstifte wird die integrierte Schaltungsanordnung EPROM mit einer externen Spannungsquelle ext zum Bereitstellen einer Betriebsspannung U_{B} verbunden. Die Schnittstelle kann auch auf andere für sich bekannte Art und Weise bereit gestellt werden, beispielsweise in Form einer Kabelverbindung oder einer Funkverbindung, beispielsweise gemäß dem Standard Bluetooth oder durch eine induktive Schnittstellenanordnung.

Der Chip weist wiederum einen Speicher M zum Speichern von Daten auf. Unter Daten sind neben vertraulichen einzelnen Datenwerten auch jegliche andere Formen von Daten einschließlich Quellcodes bzw. Programmcodes zum Betreiben einer integrierten Schaltungsanordnung oder einer externen Einrichtung zu verstehen. Der Speicher M weist einen Aufrechterhaltungsspannungsanschluss zum Anlegen einer Aufrechterhaltungsspannung U_{A} auf. Die Aufrechterhaltungsspannung U_{A} wird von der integrierten Spannungsversorgungseinrichtung FC bzw. Brennstoffzelle FC zugeführt. Neben einer beispielsweise direkten Verbindung von Spannungsversorgungseinrichtung FC und Speicher M bezüglich eines Spannungspols erfolgt die Verbindung des anderen Spannungspols über einen Sicherungsleiter SL. Der Sicherungsleiter SL führt als möglichst feiner Draht längs einer schlangenförmigen Bahn entlang der Innenseite der Gehäusewandung des Chips. Der Sicherungsleiter SL ist dabei so angeordnet und ausgelegt, dass eine Beschädigung des Gehäuses zwangsläufig auch den Sicherungsleiter SL beschädigt und dadurch die Aufrechterhaltungsspannung U_{A} für den Speicher M unterbricht. Eine Beschädigung des Gehäuses des Chips hat somit die Unterbrechung der Aufrechterhaltungsspannung U_{A} und damit zwangsläufig die Löschung der im Speicher M gespeicherten Daten zur Folge.

Bei der dargestellten Ausführungsform ist zur Bereitstellung der Betriebsspannung U_{B} neben dem externen Anschluss eine Notstromschaltung NS bereitgestellt, welche eine Verbindung zu der internen, integrierten Spannungsversorgungseinrichtung FC aufweist. Im Fall des Ausfalls der externen Betriebsspannung U_{B} wird somit die für den Betrieb der integrierten Schaltungsanordnung erforderliche Betriebsspannung von der integrierten Spannungsversorgungseinrichtung FC bereitgestellt.

Gemäß einer in Figur 3 dargestellten dritten Ausführungsform weist der Chip ebenfalls eine integrierte Schaltungsanordnung, vorliegend beispielsweise einen Direktzugriffsspeicher RAM (Random Access Memory) auf. Zum Anlegen einer Betriebsspannung U_{B} an die Schaltungsanordnung und zum Übertragen von Daten von und/oder zu externen Einrichtungen weist der Chip eine oder mehrere entsprechende Schnittstellen K in Form von Kontaktstiften auf. Außerdem weist der Chip eine Spannungsversorgungseinrichtung FC, bevorzugt wiederum eine Brennstoffzelle auf.

Zur Sicherung von Daten in einem Speicher M weist der Chip eine Sicherungsschaltung bzw. Löschschaltung LS auf. Die Sicherungsschaltung LS dient dazu, im Fall eines unberechtigten Eingriffs den Speicherinhalt bzw. die Daten im Speicher M zu löschen. Um im Fall einer unterbrochenen Betriebsspannung U_{B} das Löschen auch permanent gespeicherter Daten in dem Speicher M zu ermöglichen, ist die Sicherungsschaltung LS über entsprechende Kontakte mit der im Chip integrierten Spannungsversorgungseinrichtung FC verbunden. Die Spannungsversorgungseinrichtung FC stellt somit eine Spannung als Löschspannung U_{LS} zum Löschen von gespeicherten Daten bereit.

Die Sicherungsschaltung LS der beispielhaft dargestellten Ausführungsform überwacht als ein Löschkriterium die an dem Chip anliegende externe Betriebsspannung U_{B}. Im Fall der Unterbrechung der externen Betriebsspannung U_{B} oder eines Absinkens von dieser unter einen vorgegebenen Schwellenwert wird die Sicherungsschaltung LS zum Löschen der Daten im Speicher M aktiviert. Zur Aktivierung der Sicherungsschaltung LS ist zur Veranschaulichung ein elektromagnetischer Schalter skizziert. Daneben sind aber auch beliebige andere, insbesondere elektronische Schalt- oder Steuermechanismen einsetzbar.

Bei dieser Ausführungsform wird die Energie der integrierten Spannungsversorgungseinrichtung FC somit verwendet, z. B. kleine Stromimpulse über den Chip bzw. dessen Schaltungskomponenten zu leiten, falls ein unberechtigter Zugriff auf den Chip erfolgt. Die Stromimpulse sind dabei so stark, dass die Daten im Speicher M oder gegebenenfalls programmierte Daten einer integrierten, programmierbaren Schaltungsanordnung EPROM gelöscht werden.

Neben dem Löschkriterium der ausfallenden Betriebsspannung U_{B} ist es möglich weitere Löschkriterien zu berücksichtigen. Beispielsweise kann eine Beschädigung des Gehäuses des Chips oder die Einwirkung eines externen elektromagnetischen Feldes als Löschkriterium für die Sicherungsschaltung LS verwendet werden.

Der dargestellte Chip weist außerdem eine innere Uhr CL auf, so dass eventuelle Manipulationen oder Manipulationsversuche anhand der inneren Uhr CL rückverfolgt werden können. Mittels einer inneren Uhr CL kann auch eine aktive Löschung nach Verstreichen einer vorbestimmten Zeit bewirkt werden.

Während die beiden ersten Ausführungsformen als Sicherung der Daten das Konzept einer internen Aufrechterhaltungsspannung U_{A} für den Speicher M vorsehen, sieht das Konzept der dritten Ausführungsform vor, von der internen Spannungsversorgungseinrichtung FC eine Spannung als Löschspannung U_{LS} zum Löschen des Speicherinhalts bei einem unberechtigten Eingriff bereitzustellen. Möglich ist auch eine Kombination dieser beiden Konzepte. Bei einer solchen Kombination könnte beispielsweise die von der internen Spannungsversorgungseinrichtung FC bereitgestellte Spannung sowohl als Aufrechterhaltungsspannung U_{A} für den Speicher M als auch als eine Spannung als Löschspannung U_{LS} für eine Sicherungsschaltung LS zum aktiven Löschen von Daten in dem Speicher M bereit gestellt werden.

Alternativ oder zusätzlich zu dem Konzept der dritten Ausführungsform mit dem Anlegen einer Spannung als Löschspannung U_{LS} zum Löschen von Daten in dem Speicher kann durch die Sicherungsschaltung LS bzw. durch die von der Spannungsversorgungseinrichtung FC bereitgestellte Spannung auch eine Zerstörung wichtiger Komponenten des Chips vorgenommen werden. Beispielsweise können derart starke Stromimpulse von der Spannungsversorgungseinrichtung FC abgegeben werden, dass für die Funktion des Chips wichtige Leiterbahnen oder integrierte Schaltungsstrukturen dauerhaft zerstört werden.

Bei einer vierten anhand von Fig. 4 skizzierten Ausführungsform weist der Chip wiederum eine integrierte Schaltungsanordnung C auf. Diese steht mit externen Einrichtungen über eine Schnittstelle K zum Austausch von Daten sowie zum Anlegen einer externen Betriebsspannung U_{B} in Verbindung. Außerdem weist der Chip eine Spannungsversorgungseinrichtung FC in Form einer Brennstoffzelle FC auf. Die von der Brennstoffzelle FC abgegeben Spannung dient wiederum zum Versorgen einer Sicherungsschaltung LS. Zusätzlich oder alternativ kann die Versorgungsspannung U_{LS} auch als Aufrechterhaltungsspannung U_{A} für einen integrierten Speicher M mit vertraulichen Daten verwendet werden.

Die Anordnung von integrierter Schaltungsanordnung C und Brennstoffzelle FC ist bei der dargestellten Ausführungsform von einem Freiraum umgeben und mittels einer Halterung H an einer beabstandeten Innenwandung des Gehäuses W befestigt. In dem Freiraum befindet sich kein Reaktant, also z. B. kein Sauerstoff O₂. Vorzugsweise befindet sich im Freiraum ein Vakuum, so dass bei einer Beschädigung des Gehäuses Umgebungsluft schlagartig mit hoher Geschwindigkeit in den Freiraum eintritt. Die Umgebungsluft enthält das für die Brennstoffzelle erforderliche Reaktant O₂. Die Brennstoffzelle selber weist lediglich den Brennstoff, z. B. Wasserstoff H⁺ auf. Eine Beschädigung des Gehäuses führt somit zu einer Aktivierung der Brennstoffzelle FC, welche daraufhin die Sicherungsschaltung LS mit der Spannung als Löschspannung U_{LS} versorgt und ein Löschen der Daten im Speicher M bewirkt.

Bei diesem Konzept muss somit eine Barriere B zerstört werden, um den Zutritt des Reaktants zur Brennstoffzelle zu ermöglichen. Eine Verletzung des Gehäuses bzw. der Barriere B durch rohe Gewalt oder einen Gegenstand G führt somit zur Löschung der Daten im Speicher M.

Zu dieser Ausführungsform ist ebenfalls eine Vielzahl von Varianten möglich. Neben Kombinationen mit den vorstehenden Ausführungsformen sind dies auch eigenständige Varianten wie eine Barriere zu einem Reaktantspeicher, welcher ebenfalls im Gehäuse des Chips integriert ist. Eine solche Ausführungsform würde auch zu einer Löschung der Daten bei einer Gehäusebeschädigung führen, wenn die Beschädigung des Gehäuses unter einer Schutzatmosphäre oder in einem evakuierten Raum vorgenommen werden würde.

Bevorzugt wird der Einsatz der vorstehenden Konzepte zur integralen Versorgung von Schaltungen, insbesondere integrierten Schaltungen, wie sie für sich genommen bekannt sind. Beispielsweise kann die Energie auch benutzt werden, um Daten auf dem Chip zu halten. Beispielsweise braucht ein 8 MBit SDRAM der Firma Hitachi dafür bei einer Spannung von 1,2 V einen Strom von 6 µA. Ein weiteres Beispiel ist der DS1374 von MAXIM, bei welchem eine Spannung von 1,3 V und ein Strom von 1 µA erforderlich ist, um die Daten aufrecht zu erhalten und zu verhindern, dass jemand bei Spannungsausfall die internen Register überschreibt. Dabei wird die Energie durch ein Super-CAP oder eine Batterie extern versorgt. Gemäß den vorstehenden Konzepten könnte die Energie intern bereitgestellt werden. Dieser DS1374 enthält einen batteriegestützten Zeitzähler, eine Alarmfunktion, einen programmierbaren Rechtecksignalgeber und eine Einschalt-Rücksetzfunktion in einem 10-poligen Gehäuse. Die Schaltungsanordnung überwacht die anliegende Betriebsspannung und schützt bei Spannungsausfall die internen Register vor dem Überschreiben, führt einen Prozessor-Reset aus und schaltet auf eine Schutzversorgung durch die angeschlossene Batterie um, so dass eine Beeinträchtigung der Daten verhindert wird. Im leistungssparenden Modus erhält der Oszillator seine Funktion bei einem reduzierten Stromverbrauch aufrecht. Wenn die Betriebsspannung auf den Normalzustand zurückkehrt, hält die Schaltungsanordnung den Prozessor über eine weitere Zeitspanne im Rücksetzzustand, während sich die Betriebsverhältnisse stabilisieren. Für die Stützversorgung der Schaltungsanordnung durch eine wiederaufladbare Batterie ist eine optionale externe Erhaltungsschutzschaltung verfügbar.

Gemäß einer weiteren Schaltungsanordnung DS1672 von MAXIM sind eine erste Echtzeituhr für eine extrem niedrige Versorgungsspannung mit einer Spannungsüberwachung und Stromausfallschaltern verbunden. Ein Zählwerk kommuniziert über eine Zweidrahtschnittstelle mit einem Prozessor und zählt Sekunden, aus welchen ein Softwarealgorithmus Tageszeit, Datum, Monat und Jahr errechnet. Die Schaltungsanordnung überwacht die Versorgungsspannung und schützt bei Stromausfall die Datenspeicher für die Zeitnahme, erteilt dem Prozessor einen Rücksetzbefehl und schaltet zum Schutz vor Datenverlust auf die Notstromversorgung um, welche wiederum durch eine externe Batterie bereit gestellt wird. Im Sparbetrieb erfasst der Oszillator die Zeit auch noch bei einer deutlich reduzierten Versorgungsspannung von 1,3 V und bei einem Stormverbrauch von weniger als 400 nA.

## Patentansprüche

1. Chip mit
- einem Gehäuse,
- einem Speicher (M) zum Speichern von Daten,
- einer Versorgungseinrichtung (FC, ext) als Bestandteil des Chips zum Anlegen einer Spannung und/oder eines Stroms und
- einer Schnittstelle (K, ext) zum Übertragen von Daten von und/oder zu einer anderen Einrichtung,
**dadurch gekennzeichnet, dass**
eine Sicherungsschaltung (LS) innerhalb des Gehäuses zum Zerstören von betriebswesentlichen Bestandteilen des Chips im Fall eines unberechtigten Eingriffs vorgesehen ist, wobei die Versorgungseinrichtung (FC) eine Spannung für die Sicherungsschaltung bereitstellt, und wobei die Sicherungsschaltung (LS) das Gehäuse als Barriere (B) für einen ersten Brennstoff, insbesondere ein Reaktant (O₂) zum Betreiben einer Brennstoffzelle mit einem weiteren Brennstoff, insbesondere Wasserstoff (H⁺), als der Versorgungseinrichtung (FC) aufweist und eine Beschädigung der Barriere zum Zutritt des ersten Brennstoffs zu der Brennstoffzelle führt.

2. Chip nach Anspruch 1, bei dem
- an dem Speicher (M) eine Aufrechterhaltungsspannung (U_{A}) zum Aufrechterhalten der Daten anliegt, wobei die Daten bei Ausfallen der Aufrechterhaltungsspannung (U_{A}) gelöscht werden, und
- die Aufrechterhaltungsspannung (U_{A}) ausschließlich von der Versorgungseinrichtung (FC) bereitgestellt wird.

3. Chip nach Anspruch 2, bei dem zum Anlegen der Aufrechterhaltungsspannung (U_{A}) ein Sicherungsleiter (SL) den Speicher (M) und die Versorgungseinrichtung (FC) verbindet, wobei der Sicherungsleiter (SL) im Chip derart verlaufend angeordnet ist, dass der Sicherungsleiter (SL) bei einer Beschädigung des Chips unterbrochen wird.

4. Chip nach einem vorstehenden Anspruch mit einer Sicherungsschaltung (LS) zum Löschen der Daten in dem Speicher (M) im Fall eines unberechtigten Eingriffs.

5. Chip nach Anspruch 4, bei dem die Versorgungseinrichtung (FC) eine Spannung für die Sicherungsschaltung bereitstellt.

6. Chip nach einem der Ansprüche 1 bis 5, wobei die Sicherungsschaltung (LS) zum Überwachen einer anliegenden, insbesondere externen Betriebsspannung (U_{B}) ausgebildet ist und die Sicherungsschaltung (LS) bei Unterbrechung der Betriebsspannung die betriebswesentlichen Bestandteile des Chips zerstört bzw. die Daten im Speicher M löscht.

7. Chip nach einem vorstehenden Anspruch mit einem Betriebsspannungsanschluss (ext) zum Anlegen einer Betriebsspannung (U_{B}) zum Betreiben von Funktionen des Chips von einer externen Spannungsquelle aus.

8. Chip nach Anspruch 7 mit einer Notstromschaltung (NS) zum Bereitstellen der Betriebsspannung (U_{B}) von der Versorgungseinrichtung (FC) beim Ausfallen der Betriebsspannung (U_{B}) von der externen Spannungsquelle.

9. Chip nach einem vorstehenden Anspruch, bei dem die Versorgungseinrichtung (FC) eine Brennstoffzelle mit einer insbesondere vorgegebenen Menge an Brennstoff (H⁺) ist.

10. Chip nach einem vorstehenden Anspruch, bei dem die Versorgungseinrichtung (FC) eine Brennstoffzelle mit einer begrenzten Menge an Brennstoff (H⁺) zum Bereitstellen einer Strommenge für eine begrenzte Lebensdauer des Chips bzw. des Speicherinhalts des Speichers (M) ist.

11. Chip nach einem der Ansprüche 1 bis 10, bei dem die Versorgungseinrichtung (FC) integraler Bestandteil des Speichers (M) ist.

12. Chip nach einem vorstehenden Anspruch, bei dem als die Daten vertrauliche Daten, insbesondere ein für den Betrieb des Chips erforderlicher Schlüssel, in dem Speicher (M) gespeichert sind.

13. Chip nach Anspruch 12 mit einem Zufallsgenerator zum Erzeugen eines für den Betrieb des Chips erforderlichen und in dem Speicher (M) gespeicherten Schlüssels, insbesondere zum Erzeugen des Schlüssels bei der Herstellung oder erstmaligen Aktivierung des Chips.

14. Chip nach einem vorstehenden Anspruch mit einer Sicherungsschaltung (LS) zum Aufspielen falscher Daten in den Speicher (M) im Fall eines unberechtigten Eingriffs auf den Speicher oder den Chip.

15. Chip nach einem der Ansprüche 1 bis 14, wobei die Sicherungsschaltung (LS) zumindest einen Sensor zum Auslösen eines Alarms oder zum Aktivieren einer sonstigen Funktion der Sicherungsschaltung aufweist, wenn der Chip in eine betriebsfeindliche Umgebung kommt und/oder entsprechende Auslösekriterien für die Sensoren erfüllt werden oder vorausgesetzte Umgebungsbedingungen ausfallen.

16. Identifizierungskarte, insbesondere Kreditkarte, mit einem Chip nach einem vorstehenden Anspruch mit dem Speicher (M) zum Speichern der vertraulichen Daten und mit der Versorgungseinrichtung (FC) mit der begrenzten Strommenge zum Speichern der Daten im Speicher (M) über eine begrenzte Zeitdauer.

## Claims

1. Chip comprising
- a housing,
- a memory (M) for storing data,
- a power supply device (FC, ext) as a component of the chip for applying a voltage and/or a current, and
- an interface (K, ext) for transferring data from and/or to another device,
**characterised in that**
a security circuit (LS) is provided within the housing for destroying operationally essential components of the chip in the event of an unauthorised intervention, wherein the power supply device (FC) provides a voltage for the security circuit, and wherein the security circuit (LS) has the housing as a barrier (B) for a first fuel, in particular a reactant (O₂) for operating a fuel cell, with a further fuel, in particular hydrogen (H⁺), as the power supply device (FC), and damage to the barrier causes the first fuel to enter the fuel cell.

2. Chip according to claim 1, in which
- a preservation voltage (U_{A}) for preserving the data is applied to the memory (M), wherein the data are deleted if the preservation voltage (U_{A}) is cut off, and
- the preservation voltage (U_{A}) is provided exclusively by the power supply device (FC).

3. Chip according to claim 2, in which, in order to apply the preservation voltage (U_{A}), a security conductor (SL) connects the memory (M) and the power supply device (FC), wherein the security conductor (SL) is arranged to run in the chip in such a way that the security conductor (SL) is broken if the chip is damaged.

4. Chip according to a preceding claim, comprising a security circuit (LS) for deleting the data in the memory (M) in the event of an unauthorised intervention.

5. Chip according to claim 4, in which the power supply device (FC) provides a voltage for the security circuit.

6. Chip according to one of claims 1 to 5, wherein the security circuit (LS) is designed to monitor an applied, in particular external, operating voltage (U_{B}) and the security circuit (LS) destroys the operationally essential components of the chip and/or deletes the data in the memory (M) if the operating voltage is interrupted.

7. Chip according to a preceding claim, comprising an operating voltage terminal (ext) for applying an operating voltage (U_{B}) for operating functions of the chip from an external voltage source.

8. Chip according to claim 7, comprising an emergency current circuit (NS) for providing the operating voltage (U_{B}) from the power supply device (FC) in the event of failure of the operating voltage (U_{B}) from the external voltage source.

9. Chip according to a preceding claim, in which the power supply device (FC) is a fuel cell containing a quantity, in particular a predefined quantity, of fuel (H⁺).

10. Chip according to a preceding claim, in which the power supply device (FC) is a fuel cell containing a limited quantity of fuel (H⁺) for providing a quantity of current for a limited life span of the chip and/or of the memory contents of the memory (M).

11. Chip according to one of claims 1 to 10, in which the power supply device (FC) is an integral component of the memory (M).

12. Chip according to a preceding claim, in which the data stored in the memory (M) are confidential data, in particular a key necessary for operation of the chip.

13. Chip according to claim 12, comprising a random generator for generating a key which is necessary for operation of the chip and which is stored in the memory (M), in particular for generating the key at the time of manufacture or at the time of first activation of the chip.

14. Chip according to a preceding claim, comprising a security circuit (LS) for installing false data in the memory (M) in the event of an authorised intervention on the memory or the chip.

15. Chip according to one of claims 1 to 14, wherein the security circuit (LS) comprises at least one sensor for triggering an alarm or for activating some other function of the security circuit when the chip enters an operationally hostile environment and/or when corresponding trigger criteria for the sensors are met or predefined environmental conditions occur.

16. Identification card, in particular credit card, containing a chip according to a preceding claim comprising the memory (M) for storing the confidential data and comprising the power supply device (FC) with the limited quantity of current for storing the data in the memory (M) for a limited period of time.

## Revendications

1. Puce comprenant :
- un boîtier,
- une mémoire (M) pour enregistrer des données,
une installation d'alimentation (FC, ext) faisant partie de la puce pour appliquer une tension et/ou un courant, et
- une interface (K, ext) pour transmettre les données à partir et/ou
vers une autre installation,
**caractérisée par**
- un circuit de sécurité (LS) dans le boîtier pour détruire les composants essentiels au fonctionnement de la puce en cas d'action non autorisée,
- l'installation d'alimentation (FC) fournissant une tension au circuit de sécurité, et
- le circuit de sécurité (LS) comporte le boîtier comme barrière (B) pour un premier combustible, notamment un réactif (O₂) pour le fonctionnement d'une pile à combustible avec un autre combustible, notamment avec de l'hydrogène (H⁺) comme installation d'alimentation (FC), et un endommagement de la barrière produit l'accès du premier combustible à la pile à combustible.

2. Puce selon la revendication 1,
dans laquelle
- une tension de maintien (U_{A}) pour conserver les données est appliquée à la mémoire (M), et en cas de défaillance de la tension de maintien (U_{A}), les données sont effacées, et
- la tension de maintien (U_{A}) est fournie exclusivement par l'installation d'alimentation (FC).

3. Puce selon la revendication 2,
dans laquelle
pour appliquer une tension de maintien (U_{A}), un conducteur de sécurité (SL) relie la mémoire (M) et l'installation d'alimentation (FC), et les conducteurs de signaux (SL) se poursuivent dans la puce de façon que le circuit de sécurité (SL) soit interrompu en cas d'endommagement de la puce.

4. Puce selon l'une des revendications précédentes, comportant un circuit de sécurité (LS) pour effacer les données dans la mémoire (M) en cas d'intervention non autorisée.

5. Puce selon la revendication 4,
selon laquelle
l'installation d'alimentation (FC) fournit une tension au circuit de sécurité.

6. Puce selon l'une des revendications 1 à 5,
selon laquelle
le circuit de sécurité (LS) est réalisé pour surveiller une tension de fonctionnement (U_{B}) appliquée, en particulier une tension externe, et
en cas de dépassement vers le bas de la tension de fonctionnement, le circuit de sécurité (LS) détruit les composants essentiels au fonctionnement de la puce ou efface les données contenues dans la mémoire (M).

7. Puce selon l'une des revendications précédentes, comportant une borne d'alimentation en tension de fonctionnement (ext) pour appliquer une tension de fonctionnement (U_{B}) et gérer des fonctions de la puce à partir d'une source de tension externe.

8. Puce selon la revendication 7, comportant un circuit de courant de secours (NS) pour fournir la tension de fonctionnement (U_{B}) de l'installation d'alimentation (FC) en cas de défaillance de la tension de fonctionnement (U_{B}) vis-à-vis de la source de tension externe.

9. Puce selon l'une des revendications précédentes,
dans laquelle
l'installation d'alimentation (FC) est une pile à combustible ayant notamment une quantité prédéfinie de carburant (H⁺).

10. Puce selon l'une des revendications précédentes,
selon laquelle
l'installation d'alimentation (FC) est une pile à combustible contenant une quantité limitée de carburant (H⁺) pour fournir une quantité de courant pour une durée de vie limitée de la puce ou du contenu de la mémoire (M).

11. Puce selon l'une des revendications 1 à 10,
selon laquelle
l'installation d'alimentation (FC) fait partie intégrante de la mémoire (M).

12. Puce selon l'une des revendications précédentes,
selon laquelle
les données sont des données confidentielles, notamment le code nécessaire au fonctionnement de la puce, enregistré dans la mémoire (M).

13. Puce selon la revendication 12, comportant un générateur aléatoire pour générer un code nécessaire au fonctionnement de la puce et enregistré dans la mémoire (M), notamment pour générer la clé lors de la fabrication ou de la première activation de la puce.

14. Puce selon l'une des revendications précédentes, comportant un circuit de sécurité (LS) pour appliquer des fausses données dans la mémoire (M) en cas d'action non autorisé sur la mémoire ou la puce.

15. Puce selon l'une des revendications 1 à 14,
dans laquelle
le circuit de sécurité (LS) comporte au moins un capteur pour déclencher une alarme ou pour activer une autre fonction du circuit de sécurité si la puce arrive dans un environnement amical et/ou si des critères de déclenchement correspondants pour les autres capteurs sont remplis ou si les conditions d'environnement supposées disparaissent.

16. Carte d'identification, notamment carte de crédit comportant une puce selon l'une des revendications précédentes, ayant une mémoire (M) pour enregistrer les données confidentielles et avec l'installation d'alimentation (FC) à débit de courant limité pour mémoriser les données dans la mémoire (M) dans une période de temps limitée.
